# EUROPEAN PATENT SPECIFICATION

(11) **EP 4 193 415 B1**
(45) Date of publication and mention of the grant of the patent: **22.05.2024**
(21) Application number: 21763250.4
(22) Date of filing: 06.08.2021
(51) Int. Cl.: H01M 10/42, A24F 40/40, A24F 40/51, A61M 15/06, H01M 50/202, H01M 50/247, H01M 50/284, H01M 50/289, H01M 10/46

(54) **A BATTERY MODULE FOR AN AEROSOL GENERATING SYSTEM**
BATTERIEMODUL FÜR EIN AEROSOLERZEUGUNGSSYSTEM
MODULE DE BATTERIE POUR UN SYSTÈME DE GÉNÉRATION D'AÉROSOLS

(30) Priority: 10.08.2020 WO PCT/CN2020/108114
(43) Date of publication of application: 14.06.2023
(73) Proprietor: JT International S.A., 1202 Geneva (CH)
(72) Inventor: LI, Jun, 518102 Shenzhen Bao'an District (CN); XIE, Baofeng, 518102 Shenzhen Bao'an District (CN); LUO, Jian Cheng, 1218 Le Grand-Saconnex (CH)
(74) Representative: Santarelli
(86) International application number: PCT/EP2021/072009
(87) International publication number: WO 2022/033977

(56) References cited:
- WO-A1-2020/006305
- CA-A1- 3 096 955

## Description

### Field of the invention

The present invention relates to a battery module for an aerosol generating system.

Aerosol generating systems allow vaporization of a product, generally a liquid, often called e-liquid or e-juice. The aerosol generating systems according to the invention are also commonly called vaporizers or electronic cigarettes.

More particularly, vaporization of the product is obtained, generally by heating, in an aerosolization module, also called atomizer. Aerosolization is the conversion of a substance, for example a liquid, into particles small and light enough to be carried on the air.

Aerosol generating systems or e-cigarettes are thus portable devices comprising an electric heat source that heats the product (e-liquid) to create an aerosol that the user inhales, and a battery to power the heat source.

### Background of the invention

Several atomizer technologies and configurations are known for aerosol generating systems. Such atomizers are known as "cartomizer", "clearomizer", etc. They all use an electric powered heating device. A battery that is embedded in a battery module provides electric power to the heating device. The battery module and the atomizer can be formed as a one-piece system, but they are generally provided as separate modules.

The battery module also includes a number of electronic components. These electronic components are used to control the aerosol generating system. They generally comprise a main printed circuit board assembly that carries a microprocessor. They also generally comprise a pressure sensor making it possible to determine when the user wishes the delivery of a puff by the system. Furthermore, the battery module comprises electric contacts for battery charging.

The battery module is usually the biggest part of the aerosol generating system. To obtain a small system, which fits in a pocket and is pleasant to use, spatial optimization of the battery module is necessary.

Some aerosol generating system configurations are known in the state of the art that aim to provide a convenient shape for the aerosol generating system or optimize, to a certain extent, the dimensions of the system.

For example, US 10,0581,22 B2 discloses a vaporizer, comprising a rigid or flexible printed circuit board (PCB). Use of a flexible PCB is envisioned to provide a curved printed circuit that can be arranged in a cylindrical casing with space optimization.

However, the teaching of this document does not fully resolve the problem of the space optimization, in particular longitudinally, of the battery module. More generally, it does not solve the problem of optimal positioning of the components in the battery module.

Further relevant prior art can be found in documents CA3096955A1 and WO2020/006305A1.

The present invention aims to optimize the spatial configuration of an aerosol generating system, and more particularly the configuration of a battery module for such a system. The invention lastly aims at providing a small, portable, aerosol-generating system having a battery capacity sufficient for a convenient use.

### Summary of the invention

The present invention thus relates to a battery module for an aerosol generating system.
The battery module comprises a battery extending substantially in a longitudinal direction, such that the battery has two opposite end faces in said longitudinal direction and a side wall between said end faces, and a flexible printed circuit electrically connected to the battery. The flexible printed circuit forms a main circuit board of the battery module, the flexible printed circuit comprising a first portion which extends in the longitudinal direction over the side wall of the battery. The first portion of the flexible printed circuit carries a microprocessor or a microcontroller. The flexible printed circuit is bent such that a second portion of the flexible printed circuit extends over at least one of the end faces of the battery. The second portion of the flexible printed circuit carries a pressure sensor.

The second portion of the flexible printed circuit can for example fully cover said at least one of the end faces of the battery.

The flexible printed circuit forms a main circuit board of the battery module. The flexible printed circuit can carry electronic components configured for controlling battery parameters such as a state of charge and/or a temperature.

With such a configuration of the battery module, in which the main circuit board of the battery module covers an end face of the battery, an optimized arrangement of the components can obtained. In particular, it is possible to locate certain components of the battery module on this end face such as connectors (for re-charging the battery or for connecting the battery module to an aerosolization module) and / or a pressure sensor while ensuring their connection to the rest of the components carried by the main circuit board. Because this connexion is provided by the flexible printed circuit, it takes up very little space. Furthermore, the use of a flexible printed circuit that surrounds the battery makes it possible to connect components on opposite faces of the battery. For example, the most important components of the main circuit board, such as a microcontroller, can be located on an opposite side wall of the battery to a side wall on which the electric connexion to the battery is provided. The use of a flexible printed circuit thus allows for a very simple and optimized integration of the components in the battery modules.

The battery can have a substantially parallelepiped shape.

The flexible printed circuit is adapted to such configuration. It can be bent with small radii of curvature.

The battery module can further comprise at least one stiffening plate bonded to the flexible printed circuit.

A stiffening plate provides mechanical reinforcement to the flexible printed circuit, in particular flexural strengthening, where mechanical stresses can be applied. This is in particular the case around the connectors of the battery module, on at least one of the end faces of the battery.

A stiffening plate can be configured to stiffen the second portion of the flexible printed circuit.

The stiffening plate or plates can be made of a rigid electrical insulating material. The stiffening plate or plates can be made for example of cardboard, plastics, or wood.

The flexible printed circuit can be bent such that it comprises a third portion which extends over the opposite end face of the battery to the end face over which the second portion extends, and the battery module can comprise two stiffening plates respectively configured to stiffen each of the second portion and the third portion of the flexible printed circuit. A stiffening plate can be configured to stiffen the first portion of the flexible printed circuit.

In addition to mechanical reinforcement, the stiffening plates can help to maintain the electronic components on the flexible printed circuit. It can also enhance heat insulation between the electronic components carried by the flexible printed circuit and the battery.

The battery and the flexible printed circuit can be embedded in a battery holder frame, the battery holder frame comprising a first longitudinal end and a second longitudinal end. The battery holder frame can comprise a ferromagnetic sheet, preferably of cold rolled steel, arranged inside the battery holder frame next to one of the first longitudinal end and second longitudinal end of the battery holder frame.

The ferromagnetic sheet can allow a mechanical (magnetic) connection of the battery module to a battery charger, which includes magnetic holding means. The use of a ferromagnetic sheet (i.e. a thin plate) ensures the holding function with respect to magnets embedded in the charger. A ferromagnetic sheet takes up much less space in the battery module than magnets would.

The battery holder frame comprises at one of the first longitudinal end and second longitudinal end a connector comprising plate spring contacts.

Spring contacts are far more compact than the commonly used spring pin connectors (usually called "pogo pins ^{™}").

### Brief description of the drawings

Other particularities and advantages of the invention will also emerge from the following description.

In the accompanying drawings, given by way of non-limiting examples:
- Figure 1 represents, in a schematic three dimensional view, a battery module according to an embodiment of the invention;
- Figure 2 represents, in an exploded view, the battery module of Figure 1;
- Figure 3 represents, in a schematic three dimensional view, a flexible printed circuit used in the embodiment of Figure 1 and Figure 2.
- Figure 4 represents, in a sectional view, the battery module of Figure 1 and Figure 2;
- Figure 5 represents, in a partial sectional view of the battery module of Figure 1 and Figure 2, a first aspect of some embodiments of the invention;
- Figure 6 represents, in a partial sectional view of the battery module of Figure 1 and Figure 2, a second aspect of some embodiments of the invention.

### Detailed Description

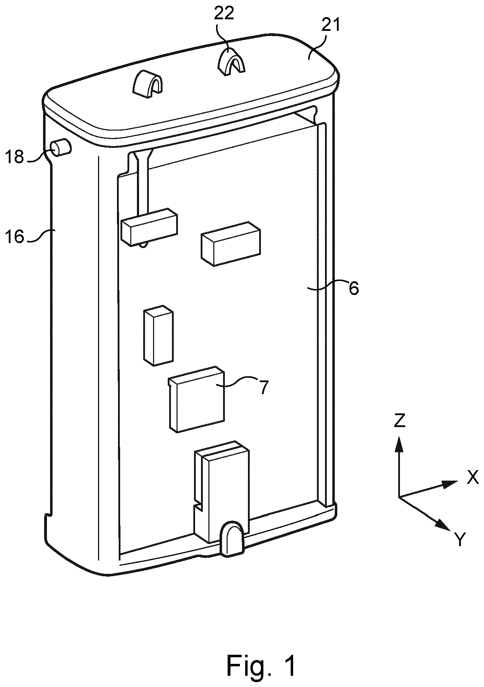

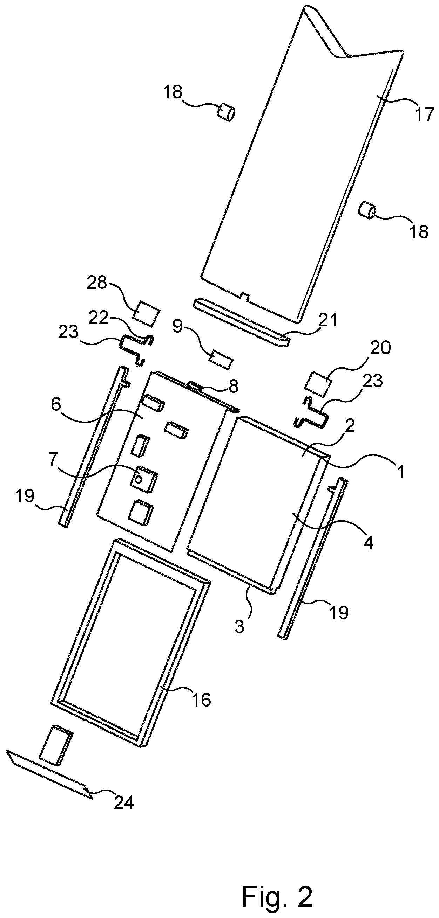

Figure 1 represents a battery module according to an embodiment of the invention. Figure 2 is an exploded view of the battery module of Figure 1, which shows the components of the assembly of the battery module of Figure 1.

The battery module comprise a battery 1. The battery can be of various technologies, including Lithium-Ion (Li-ion) and Lithium-polymer (Li-Po).The battery 1 generally comprises a single cell, but can alternatively comprise several cells in serial and/or in parallel arrangements. A 300mah to 500mha one cell Li-Po or Li-ion battery can advantageously be used. Such a battery is small and light, and allows more than 200 puffs.

Smaller batteries can also be used, and benefit from the space optimisation of the battery module obtained in the invention. For example, an 80 mAh battery, allowing more than 40 puffs can be embedded within an about 58 mm long, 17 mm wide and 9 mm thick aerosol generating system, including the battery module and an aerosolization module. A 120 mAh battery, allowing 70 puffs or more can be embedded within an about 58 mm long, 18.6 mm wide and 10.6 mm thick aerosol generating system. A 170 mAh battery, allowing 90 puffs or more can be embedded within an about 68 mm long, 17 mm wide and 9 mm thick aerosol generating system.

The battery extends substantially in a longitudinal direction Z.

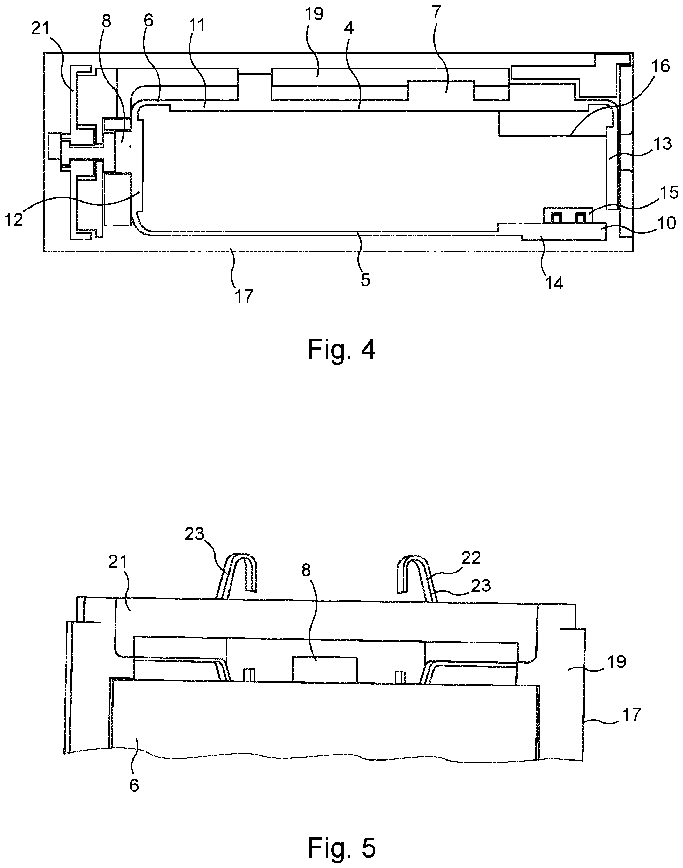

The battery 1 has two opposite ends in said longitudinal direction Z, each end forming an end face. The battery 1 thus has a first end face 2 and a second end face 3. Between the first end face 2 and a second end face 3, the battery has a side wall 4. The side wall 4 can be flat or curved, depending on the shape of the battery 1. In the represented example embodiment, the battery has a prismatic shape, and more particularly a generally parallelepiped shape (with rounded longitudinal edges). The side wall 4 is thus flat in this example embodiment. The opposite face of the battery to the side wall 4 forms a second side wall 5 (visible in Figure 4).

The battery module comprises a flexible printed circuit 6 (often designated by its acronym FPC). The FPC 6 forms the main circuit board of the battery module. The FPC 6 thus comprises the electronic component used to control the main functions of the battery module and more generally of the aerosol generating system. In particular, the FPC 6 comprises a microprocessor 7. It also comprises other electronic components.

For example, the FPC 6 can comprise the required electronic components to control battery parameters such as the state of charge and/or the temperature of the battery 1.

The FPC 6 can control the heating device of an atomizer module, when such atomizer module is connected to the battery module to form an aerosol generating system or vaporizer. The electronic components carried by the FPC 6 can more particularly control the turning on of the heating device, based on information provided by a pressure sensor 8 arranged to detect suction performed by the user on the vaporizer. The pressure sensor 8 carried by the FPC 6 is surrounded by a silicone cap 9. When a suction is applied on the vaporiser, a vacuum is created in the silicone cap that is detected by the pressure sensor 8.

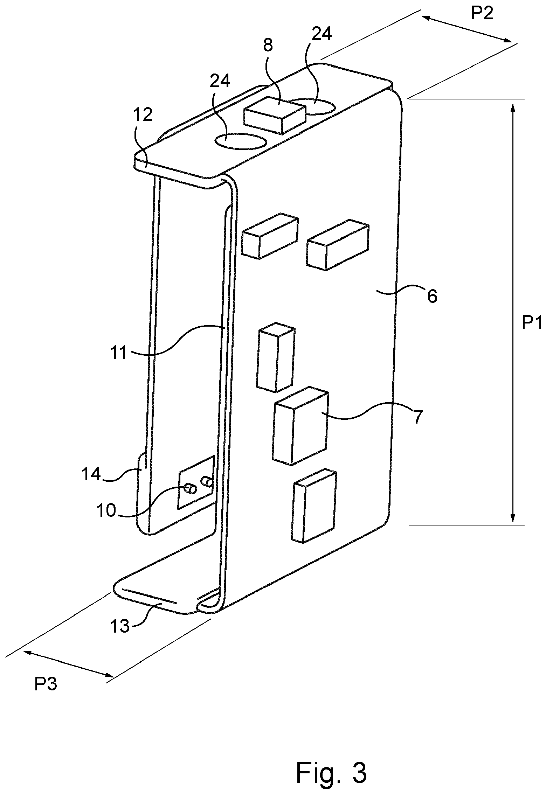

The FPC 6 extends over the side wall 4 of the battery. As shown in Figure 3, this first portion P1 of the FPC 6 which extends over the side wall 4 of the battery carries, in the represented embodiment, most of the electronic components of the battery module, and in particular the microprocessor 7.

The FPC 6 is bent such that it also covers, fully or in part, one of the end faces of the battery. In the represented embodiment, the FPC 6 fully covers both first end face 2 and second end face 3 of the battery 1.

Each FPC fold delimits a portion of the FPC 6. A second portion P2 of FPC 6 covers the first end face 2 of the battery 1. The pressure sensor 8 is carried by the second portion P2 of the FPC 6, the first end face 2 of the battery being, in the represented example embodiment, the upper face of the battery, that is situated near the interface of the battery module configured for connexion with an aerosolization module. This positioning of the pressure sensor 8 is advantageous, because it allows detection of a suction caused by the user, without having to provide a complex air path in the system. This simplifies the configuration of the system and improves its compactness.

In the represented embodiment, as shown in Figure 3, the flexible printed circuit 6 is also bent such that it comprises a third portion P3 which extends over the second end face 3 of the battery 1.

The second end face 3 of the battery 1 is the bottom face of the battery 1 that is near the interface of the battery module for connexion to a battery charger. The third portion P3 of the FPC 6 can thus advantageously comprise electrical contacts configured for connection to a charger for charging the battery.

As represented in Figure 3, the FPC 6 also comprises a fourth portion P4, which extends over the second side wall 5 of the battery 1. The fourth portion P4 comprises a board-to-board connector 10, for connexion to the battery 1.

The FPC 6 is provided with stiffening plates. Stiffening plates are fastened to the FPC 6 in areas where a mechanical reinforcement is required, or where a stiff support must be provided.

More particularly, a first stiffening plate 11 is bonded to the first portion P1 of the FPC 6. The first stiffening plate 11 is configured to provide a stiff support for the main electronic components carried by the FPC6. It also provides heat insulation between the battery 1 and said components, including the microprocessor 7.

A second stiffening plate 12 is bonded to the second portion P2 of the FPC 6. The second stiffening plate 12 is configured to support the mechanical stresses caused on the FPC 6 by a connexion or a disconnection of the battery module to or from an aerosolization module, or simply caused by a plate spring contact as hereafter explainer.

A third stiffening plate 13 is bonded to the third portion P3 of the FPC 6. The third stiffening plate 13 is configured to support the mechanical stresses caused on the FPC 6 by a connexion or a disconnection of the battery module to or from a battery charger.

Each stiffening plate is formed of a rigid, and preferably insulating, material. For example each stiffening plate can be made of plastic, cardboard, wood, resin, etc.

It should be noticed that no stiffening plate is provided on the fourth portion P4 of the FPC6, except in the area of the board-to-board connector 10, where a small fourth stiffening plate 14 is provided. Indeed, most of the fourth portion P4 is used only for electrical connexion to the battery 1, and does not require mechanical strengthening.

More particularly, as shown in Figure 4, the FPC 6 surrounds the battery 1 to connect the electrical component of the FPC to the battery. The board-to-board connector 10 is used for this connexion. The board-to-board connector 10 is situated, in the represented embodiment, at the end of the fourth portion P4 of the FPC 6. The board-to-board connector 10 is connected to a corresponding connector 15 of the battery 1. Said corresponding connector 15 is provided, in the represented embodiment, in a portion of battery of reduced thickness 16. The space freed by the thickness reduction of the battery 1 in its second portion of reduced thickness 16 is advantageously used to accommodate this connexion, without causing additional thickness of the battery.

Figure 2 represents, in an exploded view, the battery module of Figure 1.

The battery 1 is arranged in a battery holder frame 16. The battery holder frame 16 is an open rigid structure, such as a frame, which can receive the battery 1 and protect it mechanically. It also forms a support for the other parts of the battery module.

A battery tube 17 (omitted in Figure 1 to show the inner structure of the battery module) that forms the external casing of the battery module is provided. The battery tube 17 is a sheath in which all the other elements of the battery module are inserted and held in place. The battery holder frame 16 is held in place in the battery tube by holding pins 18.

On both sides of the battery holder frame 16, a spacer 19 is placed (the spacers 19 are not shown in Figure 1). The spacers 19 maintain a space between the battery 1 and the surface of the battery tube 17. This space makes it possible to house the electronic components (e.g. the microprocessor 7) carried by the flexible printed circuit 6.

Magnets 20 are positioned near the top of the battery module.

The magnets 20 are configured to interact with magnets contained in the bottom part of an aerosolization module to ensure magnetic retention of the aerosolization module on the battery module, thus forming an aerosol generating system.

The upper end of the battery module is closed by an upper cover 21. The upper cover cooperates with the upper part of the battery holder frame 16, to maintain de magnets 20 and to accommodate a connector 22. The connector 22 allows electrical connection of the battery module to an aerosolization module. The connector 22 comprises, in the represented example embodiment, plate spring contacts 23.

Alternatively, the connector 22 can comprise spring pin connectors, usually called "pogo pins ^{™}". A spring pin connector is usually made up of two sliding cylinders constrained against each other by an internal spring.

Plate spring contacts 23 are however preferred over spring pin connectors because they take up less space in the longitudinal direction Z (which is also the direction of connection of the connector), as shown in Figure 5.

The plate spring contacts 23 are connected to the FPC 6 in contact zones 23, on which they press.

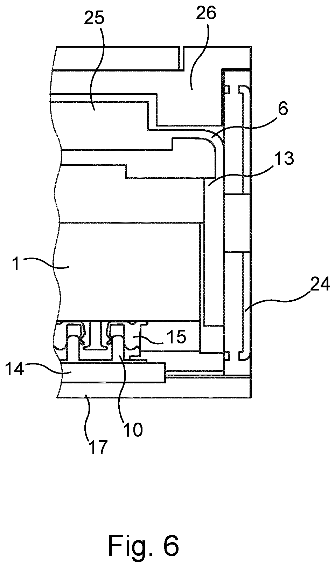

At the bottom end of the battery module, which is represented in detail in Figure 6, a ferromagnetic sheet 24 is provided in the represented embodiment. The ferromagnetic sheet 24 is fastened to the bottom part of the battery holder frame 16.

The ferromagnetic sheet 24 is attracted by the charger magnets 32 when the bottom part of the battery module is placed against a corresponding surface of a battery charger that comprises magnetic means, thus allowing the battery module (or more generally the aerosol generating system) to be held on the charger.

Use of a ferromagnetic sheet 24 instead of magnets embedded in the battery module saves longitudinal space.

In the represented embodiment, a indicator light is provided. The indicator light indicates battery or system status. The indicator light includes a light emitting diode 25 and a light guide 26.

The light guide 26 makes it possible to conduct the light emitted by the light-emitting diode 25 outside the battery tube 17 and to homogenize this light.

The battery module developed in the invention, which comprises a flexible printed circuit that forms a main circuit board of the battery module and that surrounds the battery to cover at least two faces of said battery allows spatial optimization of the battery module. More particularly, an optimized arrangement of the electronic components of the battery module can obtained. Because the connexion between the components is provided by the flexible printed circuit, it takes up very little space. Furthermore, the use of a flexible printed circuit that surrounds the battery makes it possible to connect components on opposite faces of the battery. The use of a flexible printed circuit that surrounds the battery thus allows for a very simple and optimized integration of the components in the battery modules. The invention helps in the design of a small, appealing, and convenient vaporizer.

## Claims

1. A battery module for an aerosol generating system, the battery module comprising:
- a battery (1) extending substantially in a longitudinal direction (Z) such that the battery (1) has two opposite ends in said longitudinal direction, each end forming an end face (2,3),
- a flexible printed circuit (6) connected to the battery (1), the flexible printed circuit (6) comprising a first portion (P1) which extends in the longitudinal direction (Z) over a side wall (4) of the battery (1), the flexible printed circuit (6) forming a main circuit board of the battery module, the first portion (P1) of the flexible printed circuit (6) carrying a microprocessor or a microcontroller (7),
Wherein the flexible printed circuit (6) is bent such that a second portion (P2) of the flexible printed circuit (6) extends over at least one of the end faces (2,3) of the battery (1), the second portion (P2) of the flexible printed circuit (6) carrying a pressure sensor (8).

2. A battery module according to claim 1, wherein the second portion (P2) of the flexible printed circuit (6) fully covers said at least one of the end faces (2,3) of the battery (1).

3. A battery module according to claim 1 or claim 2, wherein the flexible printed circuit (6) carries electronic components configured for controlling battery parameters such as a state of charge and/or a temperature.

4. A battery module according to any one of the preceding claims, wherein the battery (1) has a substantially parallelepiped shape.

5. A battery module according to any one of the preceding claims, wherein it further comprises at least one stiffening plate (11-14) bonded to the flexible printed circuit.

6. A battery module according to claim 5, wherein the at least one stiffening plate (11-14) is made of a rigid electrical insulating material such as cardboard, plastics, or wood.

7. A battery module according to claim 5 or claim 6, wherein the at least one stiffening plate is configured to stiffen the second portion (P2) of the flexible printed circuit (6).

8. A battery module according to claim 7, wherein the flexible printed circuit is bent such that it comprises a third portion (P3) which extends over the opposite end face of the battery to the end face over which the second portion extends, and wherein the battery module comprises two stiffening plates (12,13) respectively configured to stiffen each of the second portion (P2) and the third portion (P3) of the flexible printed circuit (6).

9. A battery module according to any one of claims 5 to 8, wherein the at least one stiffening plate is configured to stiffen the first portion (P1) of the flexible printed circuit.

10. A battery module according to any one of the preceding claims, wherein the battery (1) and the flexible printed circuit (6) are embedded in a battery holder frame (16), the battery holder frame comprising a first longitudinal end and a second longitudinal end.

11. A battery module according to claim 10, wherein it comprise a ferromagnetic sheet, preferably of cold rolled steel, arranged inside the battery holder frame (16) next to one of the first longitudinal end and second longitudinal end of the battery holder frame.

12. A battery module according to claim 10 or claim 11, wherein the battery holder frame (16) comprises at one of the first longitudinal end and second longitudinal end a connector (22) comprising plate spring contacts (23).

## Patentansprüche

1. Batteriemodul für ein Aerosolerzeugungssystem, umfassend das Batteriemodul, wobei:
- eine Batterie (1), die sich im Wesentlichen in einer Längsrichtung (Z) erstreckt, sodass die Batterie (1) zwei gegenüberliegende Enden in der genannten Längsrichtung aufweist, wobei jedes Ende eine Endfläche (2,3) bildet,
- eine flexible gedruckte Schaltung (6), die mit der Batterie (1) verbunden ist, die flexible gedruckte Schaltung (6), umfassend einen ersten Abschnitt (P1) aufweist, der sich in Längsrichtung (Z) über eine Seitenwand (4) der Batterie (1) erstreckt, wobei die flexible gedruckte Schaltung (6) eine Hauptleiterplatte des Batteriemoduls bildet, wobei der erste Abschnitt (P1) der flexiblen gedruckten Schaltung (6) einen Mikroprozessor oder einen Mikrocontroller (7) trägt, wobei die flexible gedruckte Schaltung (6) so gebogen ist, dass ein zweiter Abschnitt (P2) der flexiblen gedruckten Schaltung (6) sich über mindestens eine der Endflächen (2,3) der Batterie (1) erstreckt, wobei der zweite Abschnitt (P2) der flexiblen gedruckten Schaltung (6) einen Drucksensor (8) trägt.

2. Batteriemodul nach Anspruch 1, wobei der zweite Abschnitt (P2) der flexiblen gedruckten Schaltung (6) mindestens eine der Endflächen (2, 3) der Batterie (1) vollständig bedeckt.

3. Batteriemodul nach Anspruch 1 oder Anspruch 2, wobei die flexible gedruckte Schaltung (6) elektronische Komponenten trägt, die für die Steuerung von Batterieparametern wie einem Ladezustand und/oder einer Temperatur konfiguriert sind.

4. Batteriemodul nach einem der vorstehenden Ansprüche, wobei die Batterie (1) eine im Wesentlichen parallelepipedische Form aufweist.

5. Batteriemodul nach einem der vorstehenden Ansprüche, wobei es ferner mindestens eine Versteifungsplatte (11-14) umfasst, die mit der flexiblen gedruckten Schaltung verbunden ist.

6. Batteriemodul nach Anspruch 5, wobei die mindestens eine Versteifungsplatte (11-14) aus einem starren elektrisch isolierenden Material wie Pappe, Kunststoff oder Holz besteht.

7. Batteriemodul nach Anspruch 5 oder Anspruch 6, wobei die mindestens eine Versteifungsplatte so konfiguriert ist, dass sie den zweiten Abschnitt (P2) der flexiblen gedruckten Schaltung (6) versteift.

8. Batteriemodul nach Anspruch 7, wobei die flexible gedruckte Schaltung so gebogen ist, dass sie einen dritten Abschnitt (P3) umfasst, der sich über die der Endfläche, über die sich der zweite Abschnitt erstreckt, gegenüberliegende Endfläche der Batterie erstreckt, und wobei das Batteriemodul zwei Versteifungsplatten (12,13) umfasst, die jeweils so konfiguriert sind, dass sie sowohl den zweiten Abschnitt (P2) als auch den dritten Abschnitt (P3) der flexiblen gedruckten Schaltung (6) versteifen.

9. Batteriemodul nach einem der Ansprüche 5 bis 8, wobei die mindestens eine Versteifungsplatte so konfiguriert ist, dass sie den ersten Abschnitt (P1) der flexiblen gedruckten Schaltung versteift.

10. Batteriemodul nach einem der vorstehenden Ansprüche, wobei die Batterie (1) und die flexible gedruckte Schaltung (6) in einen Batteriehalterahmen (16) eingebettet sind, der Batteriehalterahmen, umfassend ein erstes Längsende und ein zweites Längsende.

11. Batteriemodul nach Anspruch 10, wobei es ein ferromagnetisches Blech, vorzugsweise aus kaltgewalztem Stahl, umfasst, das innerhalb des Batteriehalterahmens (16) neben einem der ersten Längsenden und zweiten Längsenden des Batteriehalterahmens angeordnet ist.

12. Batteriemodul nach Anspruch 10 oder Anspruch 11, wobei der Batteriehalterahmen (16) an einem der ersten und zweiten Längsenden einen Verbinder (22), umfassend Blattfederkontakte (23), umfasst.

## Revendications

1. Module de batterie pour un système de génération d'aérosols, le module de batterie comprenant :
- une batterie (1) s'étendant sensiblement dans une direction longitudinale (Z) de sorte que la batterie (1) présente deux extrémités opposées dans ladite direction longitudinale, chaque extrémité formant une face d'extrémité (2, 3),
- un circuit imprimé flexible (6) connecté à la batterie (1), le circuit imprimé flexible (6) comprenant une première portion (P1) qui s'étend dans la direction longitudinale (Z) au-dessus d'une paroi latérale (4) de la batterie (1), le circuit imprimé flexible (6) formant une carte de circuit imprimé principale du module de batterie, la première portion (P1) du circuit imprimé flexible (6) supportant un microprocesseur ou un microcontrôleur (7),
dans lequel le circuit imprimé flexible (6) est recourbé de sorte qu'une deuxième portion (P2) du circuit imprimé flexible (6) s'étende au-dessus d'au moins une des faces d'extrémité (2, 3) de la batterie (1), la deuxième portion (P2) du circuit imprimé flexible (6) supportant un capteur de pression (8).

2. Module de batterie selon la revendication 1, dans lequel la deuxième portion (P2) du circuit imprimé flexible (6) recouvre entièrement ladite au moins une des faces d'extrémité (2, 3) de la batterie (1).

3. Module de batterie selon la revendication 1 ou la revendication 2, dans lequel le circuit imprimé flexible (6) supporte des composants électroniques configurés pour contrôler des paramètres de batterie tels qu'un état de charge et/ou une température.

4. Module de batterie selon l'une quelconque des revendications précédentes, dans lequel la batterie (1) a une forme sensiblement parallélépipédique.

5. Module de batterie selon l'une quelconque des revendications précédentes, dans lequel il comprend en outre au moins une plaque de raidissement (11 à 14) soudée au circuit imprimé flexible.

6. Module de batterie selon la revendication 5, dans lequel l'au moins une plaque de raidissement (11 à 14) est faite d'un matériau rigide isolant électrique tel que du carton, du plastique ou du bois.

7. Module de batterie selon la revendication 5 ou la revendication 6, dans lequel l'au moins une plaque de raidissement est configurée pour raidir la deuxième portion (P2) du circuit imprimé flexible (6).

8. Module de batterie selon la revendication 7, dans lequel le circuit imprimé flexible est recourbé de sorte qu'il comprend une troisième portion (P3) qui s'étend au-dessus de la face d'extrémité de la batterie opposée à la face d'extrémité au-dessus de laquelle s'étend la deuxième portion, et dans lequel le module de batterie comprend deux plaques de raidissement (12, 13) respectivement configurées pour raidir chacune de la deuxième portion (P2) et de la troisième portion (P3) du circuit imprimé flexible (6).

9. Module de batterie selon l'une quelconque des revendications 5 à 8, dans lequel l'au moins une plaque de raidissement est configurée pour raidir la première portion (P1) du circuit imprimé flexible.

10. Module de batterie selon l'une quelconque des revendications précédentes, dans lequel la batterie (1) et le circuit imprimé flexible (6) sont encastrés dans un cadre de support de batterie (16), le cadre de support de batterie comprenant une première extrémité longitudinale et une deuxième extrémité longitudinale.

11. Module de batterie selon la revendication 10, dans lequel il comprend une tôle ferromagnétique, de préférence en acier laminé à froid, agencée à l'intérieur du cadre de support de batterie (16) à côté de l'une parmi la première extrémité longitudinale et la deuxième extrémité longitudinale du cadre de support de batterie.

12. Module de batterie selon la revendication 10 ou la revendication 11, dans lequel le cadre de support de batterie (16) comprend, au niveau d'au moins l'une parmi la première extrémité longitudinale et la deuxième extrémité longitudinale, un connecteur (22) comprenant des contacts à ressort à lame (23).
